Europäisches Patentamt

**European Patent Office**

**Office européen des brevets**

(19)

(11) Publication number: **0 020 116**
**B1**

(12) # EUROPEAN PATENT SPECIFICATION

(45) Date of publication of patent specification: **14.03.84**

(51) Int. Cl.³: **H 01 L 27/02, H 01 L 23/52**

(21) Application number: **80301734.2**

(22) Date of filing: **23.05.80**

(54) Masterslice semiconductor device and method of producing it.

(30) Priority: **24.05.79 JP 63203/79**
**25.05.79 JP 63965/79**

(43) Date of publication of application:
**10.12.80 Bulletin 80/25**

(45) Publication of the grant of the patent:
**14.03.84 Bulletin 84/11**

(84) Designated Contracting States:
**DE FR GB NL**

(56) References cited:
**FR - A - 2 374 817**
**US - A - 3 618 201**
**US - A - 3 999 214**

**IBM TECHNICAL DISCLOSURE BULLETIN, vol.
19, December 1976, New York US Y.K. PURI:
"PLA layout including second-level metallization
shorting bar", pages 2630-2631
ELECTRONICS & COMMUNICATIONS IN
JAPAN, vol. 55-C, November 1972, Tokyo, JP
TAKAHIRO OKABE et al.: "A design approach for
LSI using chip selection and circuit modification
techniques", pages 78-85**

(73) Proprietor: **FUJITSU LIMITED**
**1015, Kamikodanaka Nakahara-ku**
**Kawasaki-shi Kanagawa 211 (JP)**

(72) Inventor: **Ohno, Kenichi**
**25-12, Kamiikedai 5-chome**
**Ohta-ku Tokyo 145 (JP)**
Inventor: **Ogawa, Rokutaro**
**40-4, Fujigaoka 2-chome**
**Midori-ku Yokohama-shi Kanagawa 227 (JP)**
Inventor: **Hosomizu, Tohru**
**33-18, Hiranuma 1-chome**
**Nishi-ku Yokohama-shi Kanagawa 220 (JP)**

(74) Representative: **Abbott, Leonard Charles et al,
GILL JENNINGS & EVERY 53-64 Chancery Lane
London WC2A 1HN (GB)**

(56) References cited:
**REVIEW OF THE ELECTRICAL
COMMUNICATIONS LABORATORIES, vol. 26,
September-October 1978, Tokyo, JP K. WADA
& K. TAKEDA: "Master-slice layout design for
emitter coupled logic LSI", pages 1355-1366**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Masterslice semiconductor device and method of producing it

The present invention relates to a semiconductor device, and more particularly relates to a so-called masterslice semiconductor device.

In recent years a demand has arisen for fabrication of a large integrated semiconductor device which is suitable for low-volume, wide-variety manufacturing, without increasing the manufacturing cost and the manufacturing time. In response to this demand, the so-called masterslice semiconductor device has been proposed. In the usual masterslice semiconductor device, as is well known, first a large number of basic elements are formed on a single semiconductor substrate; however, no interconnecting lines are formed between basic elements. Each of the cells is usually comprised of basic elements, such as transistors, resistors, diodes and so on. A semiconductor substrate comprised of only such basic elements is suitable for mass production. After mass production of the semiconductor substrate, the desired interconnecting lines between the basic elements and cells are then formed thereon by using specified masks for multilayer wiring, in accordance with a variety of large scale integrated circuits to be fabricated for obtaining respective desired logic circuits.

The object of the present invention is to provide a semiconductor device, suitable for use as a masterslice LSI, which permits low-cost manufacture of various kinds of LSIs in small amounts.

According to the present invention, a masterslice semiconductor device comprises a semiconductor bulk in which a plurality of cells is formed, each cell including a plurality of basic circuit elements, first conductive lines in a first conductive layer formed on a first insulation layer of the said bulk for connecting the basic circuit elements through contact-holes in the first insulation layer, at least one of the said first conductive lines between two of the basic circuit elements in each cell comprising two separate portions, one end of each portion being connected to a respective one of the basic circuit elements, a second insulation layer formed over the first conductive lines, and a second conductive line in a second conductive layer formed over the second insulation layer, the second insulation layer being provided with a pair of through-holes which communicate respectively with the other end of the said two portions of the said first conductive line, and through which the second conductive line connects electrically the said two portions, thus connecting the said two basic circuit elements, characterized in that the second insulation layer has a predetermined pattern of through-holes and in that the device is adapted to perform a selected function by means of a plurality of second conductive lines formed in the second conductive layer over the second insulation layer for selectively connecting basic circuit elements of a cell, through appropriate through-holes selected from the said pattern of through-holes, through-holes which are not required for the selected function being plugged by conductive pads pertaining to the said second conductive layer.

In this statement of the present invention the preamble is based on the disclosure in French specification No. 2374817.

In the device according to the present invention, since the basic cells, each comprising transistors, resistors, diodes, portions of connecting lines and through-holes are originally mass produced in the semiconductor substrate, the completion of a desired device involves only preparing a mask for completing the desired interconnecting lines whenever a need for obtaining certain logic circuits occurs. Consequently, the total manufacturing time is reduced or in other words a quick turn-around time can be achieved. Furthermore, as the mass-produced cells can be utilized to obtain any of the number of kinds of logic circuits and most of the masks for producing the cells can be utilized for various types of cell, a reduction in manufactured cost can be achieved.

A method according to the invention of producing a masterslice semiconductor device comprises a plurality of cells, each cell including a plurality of basic circuit elements comprising the steps of: forming a first insulation layer over the basic circuit elements; forming a first conductive layer over the said first insulation layer for making connection to the basic circuit elements through holes in the first insulation layer, the first conductive layer including at least one conductive line comprising two separate portions, one end of each of the portions being connected to a respective one of two basic circuit elements; forming a second insulation layer over the first conductive layer; and forming a second conductive layer over the second insulation layer, the second insulation layer being provided with a pair of through-holes which communicate respectively with the other ends of the said two portions of the said conductive line, and through which the second conductive line connects electrically the said two portions, thus connecting the said two basic circuit elements; the method being characterized in that the first and second insulation layers and the first conductive layer are formed using masks of predetermined patterns, each common to a number of functions of the device, but that the second conductive layer is formed using a mask of a pattern which has been programmed such that the device is adapted to perform a selected function, the second conductive layer serving to selectively connect basic circuit elements of a cell via through-holes in the second insulation layer which are selected in accordance with the said mask programme while other through-holes are not used to connect basic circuit elements but are plugged by pads pertaining to the second conductive layer.

In order that the invention may be better understood, an example of a semiconductor device embodying the invention will now be described with reference to the accompanying drawings, in which:—

Fig. 1 is a circuit diagram of one example of a basic cell fabricated according to the present invention;

Fig. 2 is a cross-sectional view of part of a basic cell in Fig. 1;

Fig. 3 is a cross-sectional view of members 13, 13' and 18 in Fig. 1 and also their neighbouring members;

Fig. 4 is a cross-sectional view of members 15, 19, P and $R_3$ in Fig. 1 and also their neighbouring members;

Fig. 5A is an example of a pattern of the first metal layer and through-holes, and;

Fig. 5B is an example of a pattern of the uppermost metal layer of the special type of masterslice semiconductor device, embodying the present invention.

The embodiment of the invention to be described is also designed to meet certain other requirements that have arisen in connection with masterslice semiconductor devices (hereinafter referred to as simply "semiconductor devices"). One of the shortcomings of such devices which is overcome by the device to be described is that, although a great number of cells are formed on the common semiconductor substrate, not all of the cells are used to obtain the desired logic circuits. Since these non-used basic cells perform no electrical functions, but still consume electric power supplied to the semiconductor device, a first requirement is to eliminate or at least reduce such uneconomical electric power consumption.

As previously mentioned, one of the advantages of the semiconductor device is that various kinds of logic circuits can easily be fabricated merely by interconnecting lines between and in particular cells. Therefore, if the number of different kinds of logic circuits could be increased, more complicated logic functions could be achieved by the same semiconductor device. Consequently, a second requirement is to be able to easily increase the number of the various kinds of logic circuits.

Another shortcoming is that in the known semiconductor device, both the kinds of cells and the arrangement of the cells on the chip are determined, in advance, fixedly, and accordingly, the length of each interconnecting line for fabricating desired logic circuits, becomes very long. Therefore, the stray capacity formed along each interconnecting line becomes very large, and high switching speed cannot be expected. Further, since the pattern for distributing the interconnecting lines becomes complicated, manufacturing efficiency is considerably reduced. Consequently, it is desired to shorten the length of metal lines on the primary semiconductor device.

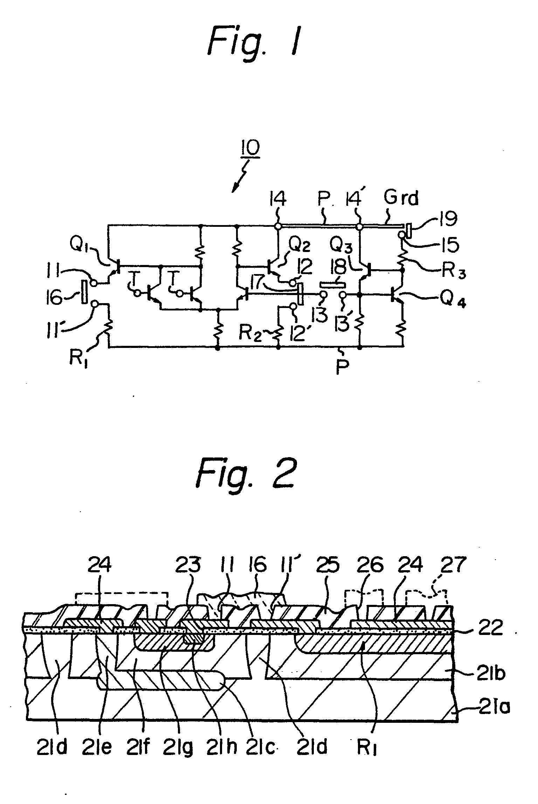

In Fig. 1, which is a circuit diagram of one example of a basic cell fabricated according to the present invention, a basic cell 10 forms a well known ECL (emitter-coupled logic) circuit. However, it should be noted that the basic cell is not limited to the ECL circuit, but can also be formed as other well known logic circuits. A large number of basic cells 10 are arranged in the semiconductor therein. However, only one of these basic cells is illustrated in Fig. 1. In this figure, the portions indicated by the small circle represent through-holes according to the present invention. Almost of these through-holes are created at a specified portion of the interconnecting lines. For example, in the basic cell (ECL circuit) 10 the through-holes 11 and 11' are formed at an emitter follower stage thereof, which is comprised of a transistor $Q_1$ and a resistor $R_1$. That is, the through-holes 11 and 11' are formed on the interconnecting line between the transistor $Q_1$ and the resistor $R_1$. First this interconnecting line is partially cut off and, then, the through-holes 11 and 11' are formed at respective open ends thereof. The open ends may also be created by partially removing the interconnecting line or partially leaving a space therein. Similarly, through-holes 12 and 12' are formed at an emitter follower stage of the basic cell (ECL circuit) 10, which is comprised of a transistor $Q_2$ and a resistor $R_2$. Also, through-holes 13 and 13' are formed on an interconnecting line between the current switch stage and a biassing stage comprised of transistors $Q_3$ and $Q_4$. Through-holes 14 and 14' are always formed in a ground line Grd. Thus, a plurality of pairs of the through-holes (11, 11'), (12, 12'), (13, 13') and so on are incorporated in both the interconnecting lines and power line of each basic cell (10). However, a single through-hole may also be incorporated therein, such as a through-hole 15 which is not part of a pair of through-holes.

In Fig. 1, portions indicated by the reference symbol T are also through-holes. These through-holes are used to connect cells or input terminal of the device, via the uppermost metal layer.

If the basic cell 10 is required to operate as a standard ECL circuit having OR/NOR gate function, the through-holes (11, 11'), (12, 12') and (13, 13') are electrically shorted by conductors 16, 17 and 18, respectively. The through-holes (14, 14') are always connected to the ground line Grd. Further, the single through-holes 15 and the ground line Grd are electrically shorted by a conductor 19.

On the other hand, if the basic cell 10 is not used in the semiconductor device, the conductors 16, 17, 18 and 19 are not incorporated therein. Accordingly, the through-holes (11, 11') through (13, 13') and the through hole 15 are left electrically open. In this case, the basic cell 10 is not energized and, accordingly, the previously mentioned first requirement is satisfied.

It is preferable to maintain many semiconductor devices to be almost the same temperature, in order to obtain good operational stability thereof. However, practically, the temperature of a certain semiconductor device may be lower than the other devices, if many cells in said certain devices are not energized. In this case, although the cells included in said certain devices are non-used cells, these cells can easily be energized later merely by mounting said conductor of the present invention thereon so as to supply power thereto. When these basic cells are energized, they will have almost the same temperature as that of the remaining devices, and accordingly, good operational stability may be satisfied.

As previously mentioned, the logic circuits of the semiconductor device should be of wide variety. Although, in Fig. 1, the basic cell 10 is initially designed as an ECL circuit, the basic cell 10 may be formed as, for example a biassing circuit merely by electrically shorting only the through-hole 15 and the ground line Grd by means of the conductor 19. Similarly, the output of the transistor $Q_1$ may be connected to another transistor (not shown), if necessary, in order to make emitter-dotting via the through-hole 11 and uppermost metal line, by not providing the conductor 16. The emitter-dotting means a connection, between the emitter of an output transistor to other circuit. Also, the through-holes (11, 11', 13, 13'...) may be utilized for creating NOR having internally terminated resistor. When an OR function is required, the through-holes (12, 12', 13, 13'...) are used. In Fig. 1, basic cells are taken as an example. However, in complicated cells, such as cells comprising flip-flops including many basic circuits, said cells can be utilized as the flip-flops or the basic gates by rearranging the distribution of the metal layer formed on the uppermost layer. Thus, the previously mentioned second requirement can be satisfied.

A part of the basic cell 10 illustrated in Fig. 1 is illustrated in a cross sectional view in Fig. 2. In this figure, the through-hole 11, the conductor 16, the transistor $Q_1$, the interconnecting line, which members are illustrated in Fig. 1, and also their neighbouring members (not shown in Fig. 1), are illustrated. The reference numeral $21_a$ represents a p-type semiconductor substrate. An n-type epitaxial growth layer $21_b$ is formed on the substrate $21_a$. An $n^+$-type buried layer $21_c$ is formed between the substrate $21_a$ and the layer $21_b$. The reference numeral $21_d$ represents a p-type or $p^+$-type isolation region which electrically isolates one basic element from adjacent basic elements. The reference numeral $21_e$ represents an $n^+$-type collector contact region. The transistor $Q_1$

of Fig. 1 is fabricated as an n-type collector region $21_f$, a p-type base region $21_g$ and an n-type emitter region $21_h$.

A first insulation layer 22 is covered on the surface of the semiconductor bulk, which is a combination of the epitaxial growth layer $21_b$ and the semiconductor substrate $21_a$. Further, first interconnecting lines 24 are formed on the first insulation layer 22. Each of the interconnecting lines 24 can electrically contact respective windows, such as windows 23, which are formed in the first insulation layer 22.

Generally, the above mentioned members $21_a$ through $21_h$, 22, and 23 comprise the conventional common semiconductor device (master semiconductor device). In the present invention, a first metal layer 24 and a second insulation layer 25 are further formed on both the first insulation layer 22 as the common masterslice devices. The second insulation layer 25 is provided with the through-holes (through-holes 11, 11', 12, 12', 13, 13', 14, 14', 15 illustrated in Fig. 1), according to the present invention, located at the specified portions and on the first interconnecting lines 24 and also as the common masterslice devices for various kinds of logic circuits. Second interconnecting line are formed on the second insulation layer 25. One of the second interconnecting lines is indicated as the conductor 16. The conductor 16 is bridged, if necessary, between the through-hole 11 and the through-hole 11' (see Fig. 2). The conductor 16 can be manufactured simultaneously with the process of manufacturing the second interconnecting lines 27, indicated by long and short dash lines. The second interconnecting lines 27 are utilized for electrically connecting other cells (not shown), conventional peripheral circuits (not shown) or chip input-output terminals via through-holes 26 formed in the layer 25. The through-holes 26 correspond to, for example, the aforesaid through-holes T in Fig. 1. The through-holes (11, 11', 26, etc., Fig. 2) are preferably formed over the edges of the first interconnecting lines 24 so that the second interconnecting lines, for example conductor 16, which interconnect the first interconnecting lines, can be as short as possible.

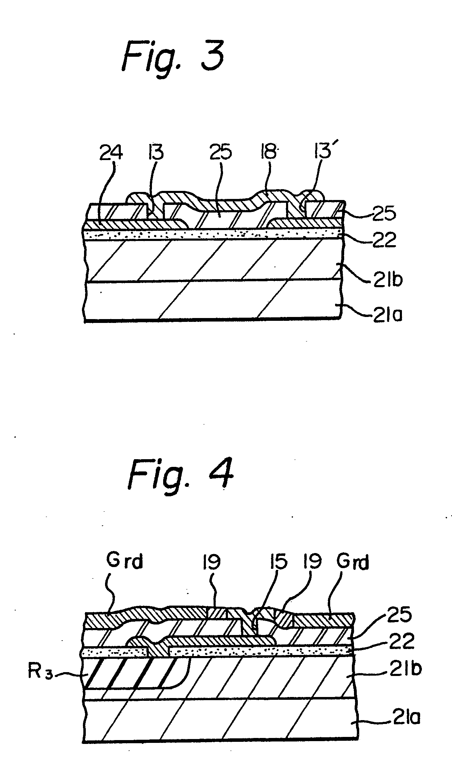

Fig. 3 is a cross sectional view of the through-holes 13, 13' and the conductor 18 in Fig. 1, and also, their neighbouring members. Fig. 4 is a cross sectional view of the through-hole 15, the conductor 19, the ground line Grd and a resistor $R_3$ in Fig. 1, and also, their neighbouring members.

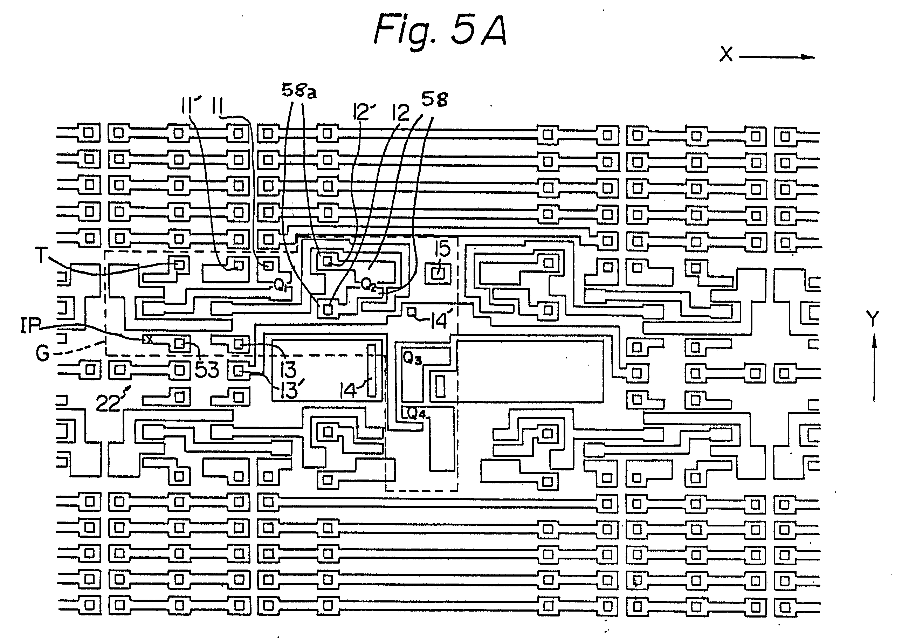

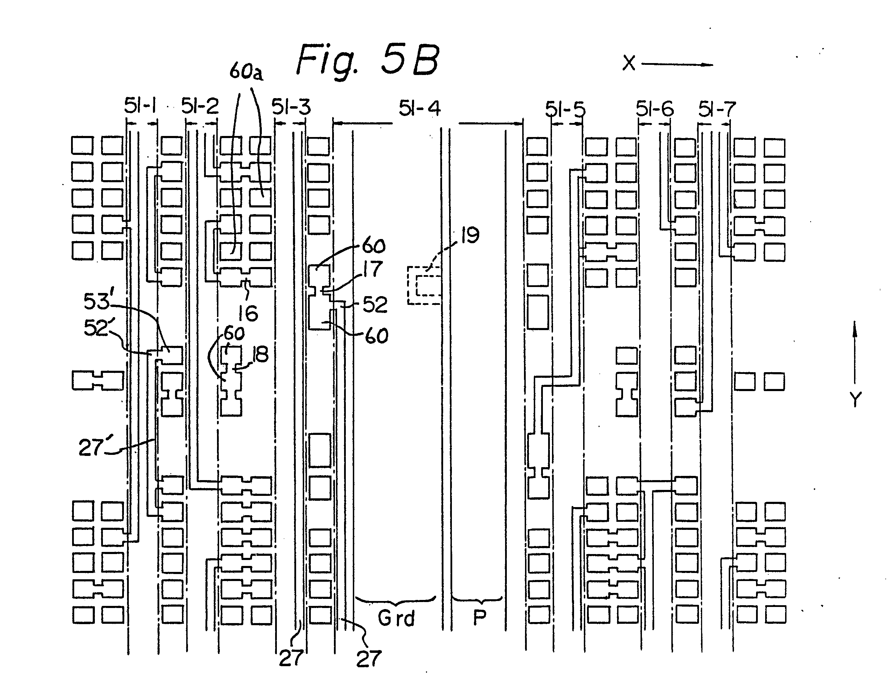

As can be seen from Figs. 1 and 2, there are many through-holes in the second insulation layer 25. Many through-holes are formed in an insulation layer with a grid-like pattern. Therefore, the through-holes (11, 11', 12, 12', 13, 13', T(26)...) may also be distributed in the second insulation layer 25 with the grid-like pattern. One example of semiconductor device is illustrated, in a plan view, in Figs. 5A and 5B.

In Fig. 5A, shows the first metal layer and the location of the through-holes which are common pattern for many logic circuits. In Fig. 5B, an example of the second metal layer (in this case, the uppermost metal layer) is illustrated, which has a specified pattern for making desired logic circuits. A pattern of certain desired ECL logic circuits can be obtained by superposing the pattern of Fig. 5B onto the pattern of Fig. 5A. In Fig. 5A, although semiconductor elements, such as transistors, resistors, are formed under the first metal layer, these semiconductor elements are not shown therein. At the middle area of Fig. 5A, both the first metal layer and the through-hole patterns are illustrated, which first metal layer can accommodate the Quad OR/NOR ECL gates, at most. For example, if the second metal layer of Fig. 5B is superposed onto the pattern of Fig. 5A, the OR/NOR gate can be fabricated at the upper left side of said middle area and the NOR gate can be fabricated at the lower left side thereof and both the OR gate and the resistor can be fabricated at the lower right side thereof, and no OR gate is fabricated at the upper right side thereof. The top metal surface of the semiconductor device is basically divided into through hole areas and line areas as shown in Fig. 5B. Areas 51-1, 51-2, 51-3, 51-4, 51-5, 51-6 ... represent the line areas. These line areas 51-1, 51-2 ... are arranged in a direction of an arrow X with predetermined pitches. On the line areas, the aforesaid interconnecting lines 27, including the conductors 17 and 19, are formed. The power line P and a ground line Grd are formed on, for example, the line area 51-4. Each of the lines extends in a direction of an arrow Y.

On the other hand, the through-holes, such as the through-holes 11, 11', 12, 12', 13, 13', 26 and so on in Fig. 5A, are formed facing the above-mentioned through-hole areas of the top metal layer, each of which is located between one line area 27 and another line area 27 adjacent thereto, and which, as shown in Figure 5B, are occupied by conductive pads 60 some of which are joined by the conductors 17, 18 to form the specified pattern. Taking as an example the conductive pads 58 of Figure 5A, these are located over elements of transistor Q2 and are connected to conductive pads 58 above which are the through-holes 12, 12' in the second insulating layer. Above these through-holes are the conductive pads 60 joined by the conductor 17. Therefore, the lines of through-hole areas and conductive pads are arranged in parallel to the line areas 27. As can be seen from Figures 5A and 5B, the second interconnecting lines 27 can freely be distributed on the device without being interrupted by the presence of the through-holes. It should be understood that the first interconnecting lines which are used to connect cells or both cells and chip peripherals (shown as the upper and lower areas of Figure 5A), are distributed on the first insulation layer in a direction of the arrow X, which is perpendicular to the arrow Y. Any of the second interconnecting lines 27 can be connected to the corresponding throughholes by way of L-shaped conductors 52.

Taking as an example a case where a gate circuit G (indicated by dotted lines in Figure 5A) having an input port IP, is fabricated on the semiconductor bulk, since the input port IP is located right beneath the line area 51-1, a direct connection from the port IP to a through-hole would involve placing the through-hole not on a "through-hole area" of Figure 5B but on a line area. Instead the input port IP is electrically connected to the nearest through-hole 53 in the second insulation layer by way of one of the first interconnecting lines 24 formed on the first insulation layer 22; this through-hole 53 faces a "through-hole area" on a line of such areas in Figure 5B. Then this first interconnecting line 24 is led to the corresponding second interconnecting line 27' via the through-hole 53, conductive pad 53' and the L-shaped conductor 52' as shown in Figure 5A and Figure 5B. As explained with reference to Figure 5A and Figure 5B, it is easy to obtain a high degree of flexibility with regard to the distribution of the second interconnecting lines and there is a capability for achieving a large integration of cells.

As will also be seen from Figure 5B, some conductive pads 60a are placed over through-holes but have no connection to any other part of the top conductive layer.

### Claims

1. A masterslice semiconductor device comprising a semiconductor bulk in which a plurality of cells (10) is formed, each cell including a plurality of basic circuit elements ($R_1$, $Q_2$ etc), first conductive lines (24) in a first conductive layer formed on a first insulation layer (22) of the said bulk for connecting the basic circuit elements through contact-holes in the first insulation layer, at least one of the said first conductive lines (24) between two of the basic circuit elements ($R_1$, $Q_1$) in each cell comprising two separate portions, one end of each portion being connected to a respective one of the basic circuit elements, a second insulation layer (25) formed over the first conductive lines (24), and a second conductive line (16) in a second conductive layer (16, 27) formed over the second insulation layer (25), the second insulation layer (25) being provided with a pair of through-holes (11, 11') which communicate respectively with the other ends of the said two portions of the said first conductive line (24), and through which the second conductive line (16) connects electrically the said two portions, thus connecting the said two basic circuit elements ($R_1$, $Q_1$), characterized in that the second insulation layer (25) has a predetermined pattern of through-holes and in that the device is adapted to perform a selected function by means of a plurality of second conductive lines (16) formed in the second conductive layer (16, 27, etc.) over the second insulation layer (25) for selectively connecting basic circuit elements of a cell, through appropriate through-holes selected from the said pattern of through-holes, through-holes which are not required for the selected function being plugged by conductive pads pertaining to the said second conductive layer.

2. A semiconductor device in accordance with claim 1, wherein the said through-holes are formed fixedly at adjacent ends of the said first conductive lines (24) which are to be connected, so that the corresponding second conductive lines (16) which connect respective first conductive lines (24) through the said through-holes (11, 11') may be as short as possible.

3. A semiconductor device in accordance with claim 1 or 2, wherein at least one of these through-holes is arranged for selective connection to a power line or ground line.

4. A semiconductor device in accordance with claim 1, 2 or 3, characterized in that through-holes formed in the second insulating layer (25) are arranged in columns extending in a given direction (Y), in that in the second conductive layer second conductive lines extend parallel to and above the spaces between the columns of through-holes in the second insulating layer, in that in the first conductive layer, conductive paths extend across the surface of the first insulating layer to link contact holes with through-holes of the said columns, and in that in the second conductive layer conductive paths extend across the surface of the second insulating layer to link the conductive lines (27) running along the inter-column spaces, with the through-holes.

5. A semiconductor device in accordance with claim 4, in which some columns of through-holes are separated by distances much smaller than the width of the above-mentioned inter-column spaces, to permit interconnection of some through-holes by short second conductive lines (16) in the second conductive layer.

6. A semiconductor device in accordance with claim 1, 2 or 3, characterized in that through-holes formed in the second insulation layer (25) are arranged in rows extending in a first direction (X) and in columns extending in a second direction (Y), perpendicular to the first direction, some columns being adjacent to one another to permit interconnection of through-holes by short second conductive lines (16) in the layer above the second insulation layer, other columns being spaced from one another, and in which in the said layer above the second insulation layer longer second conductive lines extend parallel to and over the inter-column spaces of the second insulating layer.

7. A semiconductor device in accordance with claim 6, wherein the first conductive lines (24) are arranged to extend in the said first direction (X).

8. A method of producing a masterslice semiconductor device comprising a plurality of cells, each cell including a plurality of basic circuit elements ($R_1$, $Q_1$, etc.) comprising the steps of: forming a first insulation layer (22) over the basic circuit elements; forming a first conductive layer (24) over the said first insulation layer (22) for making connection to the basic circuit elements through holes in the first insulation layer, the first conductive layer including at least one conductive line comprising two separate portions, one end of each of the portions being connected to a respective one of two basic circuit elements ($R_1$, $Q_1$); forming a second insulation layer (25) over the first conductive layer (24); and forming a second conductive layer (16, 27 etc.) over the second insulating layer (25), the second insulating layer being provided with a pair of through-holes (11, 11') which communicate respectively with the other ends of the said two portions of the said conductive line (24), and through which a line 16 of the second conductive layer connects electrically the said two portions, thus connecting the said two basic circuit elements ($R_1$, $Q_1$); the method being characterized in that the first and second insulating layers (22, 25) and the first conductive layer (24) are formed using masks of predetermined patterns, each common to a number of functions of the device, but that the second conductive layer (16, 27 etc.) is formed using a mask of a pattern which has been programmed to provide those conductive paths extending to through-holes required for the device to perform a selected function and to omit those conductive paths which are not required to extend to through-holes for the performance of the selected function, the second conductive layer serving to selectively connect to basic circuit elements of a cell via through-holes in the second insulating layer which are selected in accordance with the said mask programme while other through-holes are not used to connect basic circuit elements, but are plugged by pads pertaining to the second conductive layer.

9. A semiconductor device according to any one of claims 1 to 7, wherein the first conductive lines (24) comprise first connection pads formed at positions accessible through corresponding contact holes in the first insulating layer (22) and second connection pads formed at positions accessible through corresponding through-holes (11, 11') in the second insulating layer, and wherein the second conductive layer (16, 27 etc.) has third connecting pads formed at positions accessible to corresponding through-holes (11—11') in the second insulating layer (25).

**Patentansprüche**

1. Masterslice-Halbleitervorrichtung mit einem Halbleitervolumen, in dem eine Mehrzahl von Zellen (10) gebildet ist, welche jeweils eine Mehrzahl von Grundschaltungselementen ($R_1$, $Q_2$ etc.) umfassen, mit ersten Leitungen (24) in einer ersten leitenden Schicht, welche auf einer ersten isolierenden Schicht (22) des genannten Volumens gebildet ist, um die Grundschaltungselemente durch Kontaktlöcher in der ersten Isolierschicht zu verbinden, wobei wenigstens eine der genannten ersten Leitungen (24) zwischen zwei Grundschaltungselementen ($R_1$, $Q_1$) in jeder Zelle zwei separate Abschnitte umfaßt, von denen jeweils ein Ende mit einem entsprechenden Ende der Grundschaltungselemente verbunden ist, mit einer zweiten Isolierschicht (25), welche über den ersten Leitungen (24) gebildet ist, und mit einer zweiten Leitung (16) in einer zweiten leitenden Schicht (16, 27), welche über der zweiten Isolierschicht (25) gebildet ist die ein Paar von Durchgangslöchern (11, 11') aufweist, welche mit den jeweils anderen Enden der genannten beiden Abschnitte der genannten ersten Leitung (24) kommunizieren und durch welche die zweite Leitung (16) die beiden genannten Abschnitte elektrisch miteinander verbindet, wodurch die beiden Grundschaltungselemente ($R_1$, $Q_1$) angeschlossen werden, dadurch gekennzeichnet, daß die zweite Isolierschicht (25) ein vorbestimmtes Muster von Durchgangslöchern aufweist und daß die Vorrichtung zur Durchführung einer ausgewählten Funktion mit Hilfe einer Mehrzahl von zweiten Leitungen (16) angepaßt ist, welche in der zweiten leitenden Schicht (16, 27 etc.) über der zweiten Isolierschicht (25) gebildet sind, um wahlweise die Grundschaltungselemente einer Zelle durch geeignete Durchgangslöcher, welche von dem genannten Muster von Durchgangslöchern ausgewählt sind, zu verbinden, und daß die Durchgangslöcher, welche für die ausgewählte Funktion nicht erforderlich sind, mit Hilfe von leitenden Plättchen, welche zu der zweiten leitenden Schicht gehören, gestopft werden.

2. Halbleitervorrichtung nach Anspruch 1, bei welcher die genannten Durchgangslöcher fest an den benachbarten Enden der genannten ersten Leitungen (24) gebildet sind, welche so verbunden werden sollen, daß die entsprechenden zweiten Leitungen (16), welche die entsprechenden ersten Leitungen (24) durch die genannten Durchgangslöcher (11, 11') verbinden, so kurz wie möglich sein können.

3. Halbleitervorrichtung nach Anspruch 1 oder 2, bei welcher wenigstens eines dieser Durchgangslöcher zum wahlweisen Anschluß an eine Energieversorgungsleitung oder eine Erdleitung angeordnet ist.

4. Halbleitervorrichtung nach einem der Ansprüche 1, 2 oder 3, dadurch gekennzeichnet, daß die in der zweiten Isolierschicht (25) gebildeten Durchgangslöcher in Spalten angeordnet sind, welche sich in einer bestimmten Richtung (Y) erstrecken, daß in der zweiten leitenden Schicht zweite Leitungen sich parallel zu und oberhalb der Abstände zwischen den Spalten der Durchgangslöcher in der zweiten Isolierschicht erstrecken, daß in der ersten leitenden Schicht leitende Wege sich quer über die Oberfläche der ersten Isolierschicht erstrecken, um die Kontaktlöcher mit den Durchgangslöchern der genannten Spalten zu verbinden, und daß sich in der zweiten leitenden Schicht leitende Wege quer über die Oberfläche der zweiten isolierenden Schicht erstrecken, um die Leitungen (27), welche längs den Spaltenzwischenräumen verlaufen, mit den Durchgangslöchern zu verbinden.

5. Halbleitervorrichtung nach Anspruch 4, bei welcher einige Spalten von Durchgangslöchern durch Abstände getrennt sind, welche viel kleiner als die Breite der oben genannten Spaltenzwischenräume sind, um eine Zwischenverbindung einiger Durchgangslöcher durch kurze zweite Leitungen (16) in der zweiten leitenden Schicht zu ermöglichen.

6. Halbleitervorrichtung nach einem der Ansprüche 1, 2 oder 3, dadurch gekennzeichnet, daß die in der zweiten Isolierschicht (25) gebildeten Durchgangslöcher in Reihen, welche sich in einer ersten Richtung (X) erstrecken, und in Spalten, welche sich in einer zweiten Richtung (Y) erstrecken, die senkrecht zur ersten Richtung ist, angeordnet sind, wobei einige Spalten aneinander angrenzen, um eine Zwischenverbindung von Durchgangslöchern durch kurze zweite Leitungen (16) in der Schicht oberhalb der zweiten Isolierschicht zu erlauben, während andere Spalten einen Abstand voneinander aufweisen, und bei welcher sich in der genannten Schicht oberhalb der zweiten Isolierschicht längere zweite Leitungen parallel zu und über den Spaltenzwischenräumen der zweiten Isolierschicht erstrecken.

7. Halbleitervorrichtung nach Anspruch 6, bei welcher die ersten Leitungen (24) so angeordnet sind, daß sie sich in der ersten Richtung (X) erstrecken.

8. Verfahren zur Herstellung einer Masterslice-Halbleitervorrichtung mit einer Mehrzahl von Zellen, welche jeweils eine Mehrzahl von Grundschaltungselementen ($R_1$, $Q_1$ etc.) umfassen, mit den folgenden Schritten: Bildung einer ersten Isolierschicht (22) über den Grundschaltungselementen, Bildung einer ersten leitenden Schicht (24) über der genannten ersten Isolierschicht (22), zur Herstellung der Verbindung mit den Grundschaltungselementen durch die Durchgangslöcher in der ersten Isolierschicht, wobei die erste leitende Schicht wenigstens eine Leitung umfaßt, welche zwei separate Abschnitte aufweist, von denen jeweils ein Ende mit einem entsprechenden von zwei Grundschaltungselementen ($R_1$, $Q_1$) verbunden ist, Bildung einer zweiten Isolierschicht (25) über der ersten leitenden Schicht (24), Bildung einer zweiten leitenden Schicht (16, 27 etc.) über der zweiten Isolierschicht (25), welche ein Paar von Durchgangslöchern (11, 11') aufweist, welche jeweils mit den anderen Enden der genannten zweiten Abschnitte der genannten Leitung (24) kommunizieren, und durch welche eine Leitung (16) der zweiten leitenden Schicht die genannten beiden Abschnitte elektrisch verbindet, und somit die beiden Grundschaltungselemente (R₁, Q₁) anschließt, dadurch gekennzeichnet, daß die erste und die zweite Isolierschicht (22, 25) und die erste leitende Schicht (24) unter Verwendung von Masken vorbestimmter Muster gebildet werden, welche jeweils einer Anzahl von Funktionen der Vorrichtung gemeinsam sind, daß aber die zweite leitende Schicht (16, 27 etc.) unter Verwendung einer Maske mit einem Muster gebildet wird, welches programmiert worden ist, um diejenigen leitenden Wege vorzusehen, welche sich zu den Durchgangslöchern erstrecken, die erforderlich sind, damit die Vorrichtung eine ausgewählte Funktion durchführen kann und um diejenigen leitenden Wege auszulassen, welche sich, um die ausgewählte Funktion durchzuführen, nicht zu den Durchgangslöchern erstrecken müssen, wobei die zweite leitende Schicht dazu dient, wahlweise die Grundschaltungselemente einer Zelle über die Durchgangslöcher in der zweiten Isolierschicht zu verbinden, welche in Übereinstimmung mit dem genannten Maskenprogram ausgewählt werden, während andere Durchgangslöcher nicht zur Verbindung von Grundschaltungselementen verwendet sondern mit Plättchen gestopft werden, welche zu der zweiten leitenden Schicht gehören.

9. Halbleitervorrichtung nach einem der Ansprüche 1 bis 7, bei welcher die ersten Leitungen (24) erste Verbindungsplättchen umfassen, welche an Positionen gebildet sind, die durch entsprechende Kontaktlöcher in der ersten Isolierschicht (22) zugänglich sind, und bei welcher zweite Verbindungsplättchen an Positionen gebildet sind, welche durch entsprechende Durchgangslöcher (11, 11') in der zweiten Isolierschicht zugänglich sind und bei welcher die zweite leitende Schicht (16, 27 etc.) dritte Verbindungsplättchen hat, welche an Positionen gebildet sind, die durch entsprechende Durchgangslöcher (11, 11') in der zweiten Isolierschicht (25) zugänglich sind.

## Revendications

1. Dispositif semi-conducteur "passe-partout" comprenant un substrat semi-conducteur dans lequel sont formées plusieurs cellules (10) comprenant chacune plusieurs éléments de circuit de base (R₁, Q₁, etc.), des premières lignes conductrices (24) dans une première couche conductrice formée sur une première couche isolante (22) du substrat pour connecter lesdits éléments de circuit de base par des trous de contact dans la première couche isolante, au moins l'une desdites premières lignes conductrices (24) entre deux des éléments de circuit de base (R₁, Q₁) dans chaque cellule comprenant deux parties séparées, une extrémité de chaque partie étant connectée à l'un respectif des éléments de circuits de base, une seconde couche isolante (25) formée sur les premières lignes conductrices (24) et une seconde ligne conductrice (16) dans une seconde couche conductrice (16, 27) formées sur la second couche isolante (25), la seconde couche isolante (25) étant prévue avec une paire de trous de traversée (11, 11') qui communiquent respectivement avec les autres extrémités desdites deux parties de ladite première ligne conductrice (24) et par lesquels la seconde ligne conductrice (16) connecte électriquement lesdites deux parties, connectant ainsi lesdits deux éléments de circuit de base (R₁, Q₁), caractérisé en ce que la seconde couche isolante (25) comporte une configuration prédéterminée de trous de traversée et en ce que le dispositif est adapté pour remplir une fonction déterminée au moyen de plusieurs secondes lignes conductrices (16) formées dans la seconde couche conductrice (16, 27, etc.) sur la seconde couche isolante (25) pour connecter sélectivement des éléments de circuit de base d'une cellule par des trous de traversée appropriés sélectionnés dans ladite configuration des trous de traversée, les trous de traversée qui ne sont pas nécessaires pour la fonction sélectionnée étant bouchés par des tampons conducteurs appartenant à ladite seconde couche conductrice.

2. Dispositif semi-conducteur selon la revendication 1, dans lequel lesdits trous de traversée sont formés de façon fixe à des extrémités voisines desdites premières lignes conductrices (24) qui doivent être connectées de manière que les secondes lignes conductrices (16) correspondantes qui connectant des premières lignes conductrices (24) respectives par lesdits trous de traversée (11, 11') puissent être aussi courtes que possible.

3. Dispositif semi-conducteur selon la revendication 1 ou 2, dans lequel l'un au moins desdits trous de traversée est disposé pour une connexion sélective avec une ligne d'alimentation ou une ligne de masse.

4. Dispositif semi-conducteur selon la revendication 1, 2 ou 3 caractérisé en ce que des trous de traversée formés dans ·la seconde couche isolante (25) sont disposés dans des colonnes s'étendant dans une direction donnée (Y), en ce que, dans la seconde couche conductrice, des secondes lignes conductrices s'étendent parallèlement et au-dessus des espaces entre les colonnes des trous de traversée dans la seconde couche isolante, en ce que, dans la première couche conductrice, des circuits conducteurs s'étendent sur la surface de la première couche isolante pour relier des trous de contact avec des trous de traversée desdites colonnes, et en ce que, dans la seconde couche conductrice, des circuits conducteurs s'étendent sur la surface de la seconde couche isolante, pour relier les lignes conductrices (27) disposées le long des espaces entre les colonnes, avec les trous de traversée.

5. Dispositif semi-conducteur selon la revendication 4 dans lequel certaines colonnes de trous de traversée sont séparées par des distances beaucoup plus petites que la largeur des espaces précités entre les colonnes pour permettre l'interconnexion de certains des trous de traversée par de courtes secondes lignes conductrices (16) dans la seconde couche conductrice.

6. Dispositif selon la revendication 1, 2 ou 3, caractérisé en ce que les trous de traversée formés dans la seconde couche isolante (25) sont disposés en rangées s'étendant dans la première direction (X) et en colonnes s'étendant dans une seconde direction (Y), perpendiculaire à la première direction, certaines colonnes étant voisines l'une de l'autre pour permettre l'interconnexion de trous de traversée par de courtes secondes lignes conductrices (16) dans la couche au-dessus de la seconde couche isolante, d'autres colonnes étant espacées les unes des autres et dans lesquelles, dans ladite couche au-dessus de la seconde couche isolante, de plus longues secondes lignes conductrices s'étendent parallèlement et au-dessus des espaces entre les colonnes de la seconde couche isolante.

7. Dispositif semi-conducteur selon la revendication 6, dans lequel les premières lignes conductrices (24) sont disposées pour s'étendre dans ladite première direction (X).

8. Procédé de production d'un dispositif semi-conducteur passe partout comprenant plusieurs cellules, comprenant chacune plusieurs éléments de circuits de base ($R_1$, $Q_1$, etc.), consistant à former une première couche isolante (22) sur les éléments de circuits de base, à former une première couche conductrice (24) sur ladite première couche isolante (22) pour établir une connexion avec les éléments de circuits de base par des trous de traversée dans la première couche isolante, la première couche conductrice comprenant au moins une ligne conductrice consistant en deux parties séparées, une extrémité de chacune des parties étant connectée à l'un respectif des deux éléments de circuit de base ($R_1$, $Q_1$) à former une seconde couche isolante (25) sur la première couche conductrice (24) et à former une seconde couche conductrice (16, 27, etc.) sur la seconde couche isolante (25), la seconde couche isolante étant prévue avec une paire de trous de traversée (11, 11') qui communiquent respectivement avec les autres extrémités desdites deux parties de ladite ligne conductrice (24) et par lesquels une ligne (16) de la seconde couche conductrice connecte électriquement lesdites deux parties, connectant ainsi lesdits deux éléments de circuit de base ($R_1$, $Q_1$), procédé caractérisé en ce que la première et la seconde couches isolantes (22, 25) et la première couche conductrice (24) sont formées en utilisant des masques de configuration prédéterminés, communs chacun à un certain nombre de fonctions du dispositif, mais en ce que la seconde couche conductrice (16, 27, etc.) est formée en utilisant un masque d'une configuration qui a été programmée pour produire les circuits conducteurs s'étendant jusqu'aux trous de traversée nécessaires pour que le dispositif remplisse une fonction déterminée et en supprimant les circuits conducteurs dont il n'est pas nécessaire qu'ils s'étendent jusqu'aux trous de traversée pour remplir la fonction déterminée, la seconde couche conductrice servant à être connecté sélectivement aux éléments de circuit de base d'une cellule par des trous de traversée dans la seconde couche isolante qui sont sélectionnés en fonction dudit programme de masque tandis que d'autres trous de traversée ne sont pas utilisés pour connecter des éléments de circuit de base mais sont bouchés par des tampons appartenant à la seconde couche conductrice.

9. Dispositif semi-conducteur selon l'une quelconque des revendications 1 à 7, dans lequel les premières lignes conductrices (24) comprennent des premières surfaces de connexion formées dans des positions accessibles par des trous de contact correspondants dans la première couche isolante (22), et des secondes surfaces de connexion formées dans les positions accessibles pour des trous de traversée correspondant (11, 11') dans la seconde couche isolante, et dans lequel la seconde couche conductrice (16, 27, etc.) comporte des troisièmes surfaces de connection formées dans des positions accessibles par des trous de traversée correspondant (11, 11') dans la seconde couche isolante (25).

# Fig. 1

# Fig. 2

## Fig. 3

## Fig. 4

Fig. 5A

Fig. 5 B